# EUROPEAN PATENT APPLICATION

(11) **EP 4 711 842 A1**
(43) Date of publication of application: **18.03.2026**
(21) Application number: 25201545.8
(22) Date of filing: 11.09.2025
(51) Int. Cl.: G02F 1/1345, H10K 59/131

(54) **DISPLAY APPARATUS**

(30) Priority: 13.09.2024 KR 20240125970
(71) Applicant: Samsung Display Co., Ltd., Yongin-si, Gyeonggi-do 17113 (KR)
(72) Inventor: LEE, Geun-Ho, 17113 Giheung-gu, Yongin-si, Gyeonggi-do (KR); PARK, Dongjoo, 17113 Giheung-gu, Yongin-si, Gyeonggi-do (KR)
(74) Representative: Dr. Weitzel & Partner

(57) **Abstract**

A display apparatus includes a display panel including a display element generating visible light, a protective panel disposed to face one surface of the display panel, a circuit board disposed to face the protective panel to apply an electrical signal to the display panel, and a circuit cover portion including a main region, a wing region connected to the main region, located between the circuit board and the protective panel, and electrically connected to the circuit board, and a connection region disposed in the main region and electrically connected to the protective panel in a region different from the wing region.

## Description

The present invention relates to a display apparatus and a method of manufacturing a display apparatus.

In recent years, the uses of display apparatuses have become more diverse. In addition, display apparatuses have become thinner and lighter, and the range of uses thereof has expanded.

In addition, as the fields of use of display apparatuses have expanded and the technology utilizing display apparatuses has advanced, the picture quality and high resolution characteristics required for display apparatuses have increased.

There are limits to improving electrical characteristics and durability due to the need for precise characteristic control and thinning of display apparatuses.

Embodiments of the present invention provide a display apparatus having improved electrical characteristics and durability and a method of manufacturing a display.

Additional aspects will be set forth in part in the description which follows and, in part, will be apparent from the description, or may be learned by practice of the presented embodiments of the invention.

The present invention is defined by the features of the independent claims. The dependent claims and the description provide preferred embodiments.

According to an aspect of the inventive concept, there is provided a display apparatus including a display panel including a display element generating visible light, a protective panel disposed to face one surface of the display panel, a circuit board disposed to face the protective panel to apply an electrical signal to the display panel, and a circuit cover portion including a main region, a wing region connected to the main region, located between the circuit board and the protective panel, and electrically connected to the circuit board, and a connection region disposed in the main region and electrically connected to the protective panel in a region different from the wing region.

The wing region and the main region may overlap each other.

At least one region of the circuit board may be located between the wing region and the main region.

A region of the wing region may be in direct contact with a region of the circuit board.

A region of the connection region may be in direct contact with a region of the protective panel.

The circuit cover portion may include a conductive layer and an insulating layer on at least one surface of the conductive layer.

The wing region may include a region in which a surface of the conductive layer is not covered with the insulating layer.

The connection region of the circuit cover portion may include a region in which a surface of the conductive layer is not covered with the insulating layer.

The insulating layer may be a first insulating layer disposed on one surface of the conductive layer and a second insulating layer may be disposed on an opposite surface of the conductive layer.

The conductive layer may be disposed to correspond to the main region, the wing region, and the connection region.

The circuit board may include a conductive region and an insulating base layer on at least one surface of the conductive region.

The circuit board may include a conductive exposure region in at least one region, and the conductive exposure region may include an exposed surface not covered by the insulating base layer in a region of the conductive region.

The conductive exposure region may be disposed to overlap the wing region.

The conductive exposure region may have a length or width less than a length or width of the circuit board.

The protective panel may include a protective conductive layer to correspond to at least the connection region of the circuit cover portion, and the protective conductive layer may be electrically connected to the connection region.

The circuit cover portion may be disposed to be bent to surround at least one side of the circuit board, and the connection region of the circuit cover portion may be connected to the protective panel at a position apart from the circuit board.

A conductive path for grounding may be formed through an electrical path of the circuit board and the wing region of the circuit cover portion and an electrical path of the connection region of the circuit cover portion and the protective panel.

An electrical path may be formed between the circuit board and the protective panel through the circuit cover portion.

The wing region of the circuit cover portion may be disposed to protrude from the main region.

The display element of the display panel may be disposed on a substrate, the protective panel may be disposed to face the substrate, and the circuit cover portion may be disposed to face the protective panel.

According to another aspect of the inventive concept, there is provided a method of manufacturing a display apparatus including preparing a display panel including a display element that generates visible light, preparing a protective panel disposed to face one surface of the display panel, preparing a circuit board disposed to face the protective panel to apply an electrical signal to the display panel, and preparing a circuit cover portion including a main region, a wing region connected to the main region, located between the circuit board and the protective panel, and electrically connected to the circuit board, and a connection region located in the main region and electrically connected to the protective panel in a region different from the wing region.

The wing region may be disposed to protrude from the main region.

The method may further include bending or folding the wing region to overlap the circuit board and then bending a region of the main region.

In the bending the region of the main region, the main region may be bent to cover the wing region.

The connection region may be electrically connected to the protective panel through the bending.

According to another aspect of the inventive concept, there is provided an electronic device comprising a display apparatus, and the display apparatus includes a display panel including a display element generating visible light, a protective panel disposed to face one surface of the display panel, a circuit board disposed to face the protective panel to apply an electrical signal to the display panel, and a circuit cover portion including a main region, a wing region connected to the main region, located between the circuit board and the protective panel, and electrically connected to the circuit board, and a connection region disposed in the main region and electrically connected to the protective panel in a region different from the wing region.

Other aspects, features and advantages other than those described above will become apparent from the following drawings, claims and detailed description of the inventive concept.

The and other aspects, features, and advantages of certain embodiments of the invention will be more apparent from the following description taken in conjunction with the accompanying drawings.
FIG. 1 is a cross-sectional view schematically illustrating a display apparatus according to an embodiment of the present invention.
FIG. 2 is an enlarged view of region K of FIG. 1.
FIG. 3 is a schematic plan view viewed in direction A of FIG. 1.
FIG. 4 is a cross-sectional view taken along line IV-IV' of FIG. 3.
FIG. 5 is an enlarged view of Q in FIG. 4.
FIG. 6 is a cross-sectional view schematically illustrating an example of a display panel of FIG. 1.
FIG. 7 is a cross-sectional view schematically illustrating an example of the display panel of FIG. 1.
FIG. 8 is a cross-sectional view illustrating an example of a circuit board of the display apparatus of FIG. 1.
FIG. 9 is a plan view of FIG. 8 viewed in one direction.
FIG. 10 is a plan view illustrating an example of a circuit cover portion of the display apparatus of FIG. 1.
FIG. 11 is a cross-sectional view taken along line XI-XI' of FIG. 10.
FIG. 12 is a cross-sectional view taken along line XII-XII' of FIG. 10.
FIG. 13 is a cross-sectional view schematically illustrating a display apparatus according to an embodiment of the present invention.
FIG. 14 is a plan view viewed in direction K of FIG. 13.
FIG. 15 is a cross-sectional view taken along line XV-XV' of FIG. 14.
FIG. 16 is an enlarged view of region S of FIG. 15.
FIGS. 17, 18, 19, 20, and 21 are views illustrating an example of disposing a circuit cover portion of the display apparatus of FIG. 13.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions, such as "at least one of," when preceding a list of elements, modify the entire list of elements and do not modify the individual elements of the list.

As the present invention allows for various changes and numerous embodiments, particular embodiments are illustrated in the drawings and described in detail in the written description. The advantages and features of the embodiments and methods of achieving them will be apparent from the following embodiments that will be described in more detail with reference to the accompanying drawings. However, the present invention is not limited to the embodiments disclosed below and may be implemented in various forms.

In the following embodiments, terms, such as "first," "second," etc. are used not in a limiting sense but for the purpose of distinguishing one component from another component.

In the following examples, singular terms include plural terms unless the context clearly dictates otherwise.

In the following embodiments, the terms such as "including" "having," and "comprising" are intended to indicate the existence of the features or components disclosed in the specification, and are not intended to preclude the possibility that one or more other features or components may exist or may be added.

In the following examples, when a part, such as a film, region, component, etc. is mentioned to be on or above another part, it includes not only a case in which the part is directly on top of the other part, but also a case in which another film, region, component, etc. is interposed in between.

In the drawings, the sizes of components may be exaggerated or reduced for convenience of description. For example, the size and/or thickness of each component shown in the drawings are arbitrarily shown for convenience of description, so the following embodiments are not necessarily limited to that shown.

In the following description, x, y, and z axes are not limited to three axes on an orthogonal coordinate system, and may be interpreted in a broader sense. For example, the x, y, and z axes may refer to different directions that are orthogonal or non-orthogonal to each other.

When a certain embodiment may be implemented differently, a specific process order may be performed differently from the described order. For example, two consecutively described processes may be performed substantially at the same time or performed in an order opposite to the described order.

Hereinafter, embodiments of the present invention will be described in detail with reference to the accompanying drawings, and when described with reference to the drawings, the same or corresponding components are given the same reference numerals, and repeated descriptions thereof will be omitted.

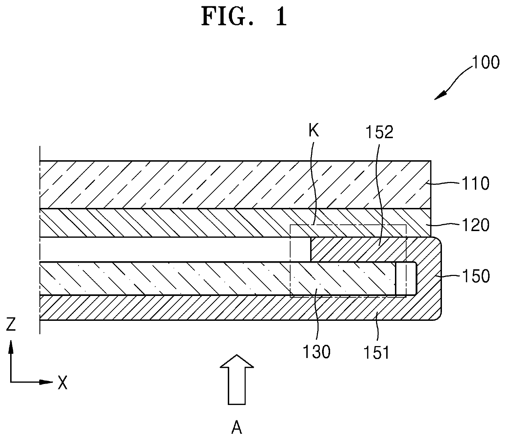

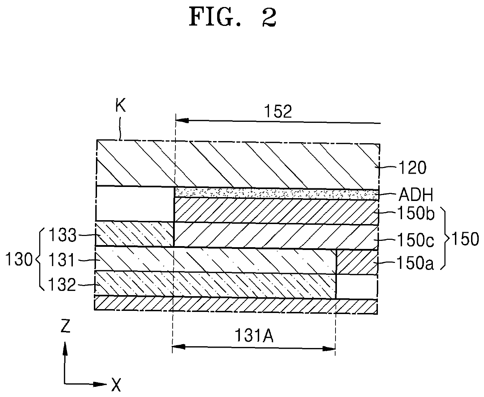

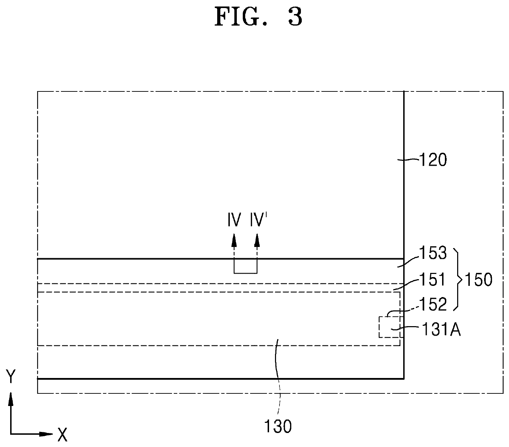

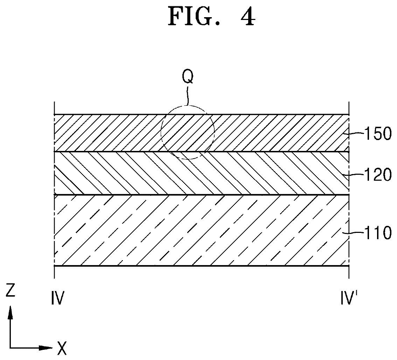

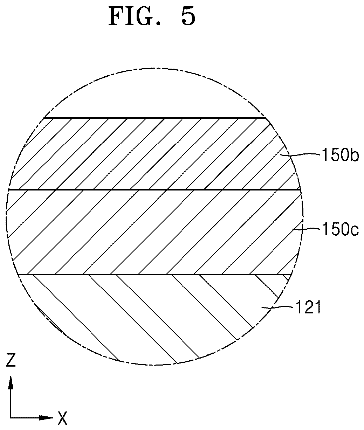

FIG. 1 is a cross-sectional view schematically illustrating a display apparatus 100 according to an embodiment of the present invention. FIG. 2 is an enlarged view of region K of FIG. 1. FIG. 3 is a schematic plan view viewed in direction A of FIG. 1. FIG. 4 is a cross-sectional view taken along line IV-IV' of FIG. 3. FIG. 5 is an enlarged view of Q in FIG. 4.

Referring to FIG. 1, the display apparatus 100 may include a display panel 110, a protective panel 120, a circuit board 130, and a circuit cover portion 150.

The display panel 110 may include a display unit that generates visible light. For example, the display panel 110 may include one or more display elements arranged on a substrate, and the display elements included in the display panel 110 may be organic light emitting diodes (OLEDs), and in embodiments, may include liquid crystal display (LCDs), light emitting diodes (LEDs), quantum dot elements, etc. The display panel 110 is described below with reference to FIGS. 5 to 7.

The protective panel 120 may be disposed to face one surface of the display panel 110. For example, when a main surface of the display panel 110 on which an image is implemented is referred to as a front surface, the protective panel 120 may be disposed to face a rear surface, which is the opposite surface of the front surface of the display panel 110. As an example, because an upper surface of the display panel 110 is the front surface and the main surface on which an image is implemented based on FIG. 1, the protective panel 120 may be disposed on a lower surface of the display panel 110.

The protective panel 120 may protect the display panel 110, and for example, may reduce or prevent the display panel 110 from being damaged or deformed by external impact, and as an example, may reduce or prevent the display panel 110 from being damaged or deformed by external light, and may reduce or prevent the display panel 110 from being damaged or deformed by heat or electromagnetic waves.

As an example, the protective panel 120 may include a protective layer, and as an example, may include a cushion layer that absorbs shock. As an example, the protective panel 120 may include a light absorbing layer that absorbs external light. In some embodiments, as an example, the protective panel 120 may include a heat dissipation layer that dissipates heat or an electromagnetic shielding layer that shields electromagnetic waves.

In some embodiments, the protective panel 120 may include one or more conductive ground layers or conductive ground patterns for grounding.

The circuit board 130 may be disposed to face the protective panel 120 to apply an electrical signal to the display panel 110. In some embodiments, the circuit board 130 may include one or more circuit regions, and may include, for example, an integrated circuit chip. In some embodiments, the circuit board 130 may include a printed circuit board.

In an embodiment, although not shown, the circuit board 130 may be electrically connected to the display panel 110 through a connecting circuit portion (not shown). The connecting circuit portion (not shown) may include a material flexible to be bent in a state of being connected to the display panel 110 and the circuit board 130.

The circuit cover portion 150 may be disposed to cover at least one region of the circuit board 130, and as an example, may be located to cover the entire circuit board 130.

The circuit cover portion 150 may be disposed to cover a circuit region (e.g., a driving integrated circuit chip) on the display panel 110 or a circuit region of the circuit board 130 to protect the circuit region. For example, the circuit cover portion 150 may protect the circuit region from external contact, pressure, or electromagnetic waves.

The circuit cover portion 150 may include at least a conductive layer and a protective insulating layer disposed on at least one surface of the conductive layer.

The circuit cover portion 150 may include at least a main region 151, a wing region 152, and a connection region 153.

The main region 151 of the circuit cover portion 150 may have a length in one direction (an X-axis direction of FIG. 1) and a width in a direction (a Y-axis direction of FIG. 3) intersecting the X-axis direction.

The wing region 152 may be connected to the main region 151 and located between the circuit board 130 and the protective panel 120.

In some embodiments, the wing region 152 may be electrically connected to the circuit board 130. In some embodiments, the wing region 152 may protrude from the main region 151 in a length direction. The wing region 152 may be bent to overlap the main region 151. In some embodiments, the circuit board 130 may be disposed on the main region 151, and the wing region 152 disposed to extend beyond the opposing edges of the circuit board 130 may be bent to come into contact with a region of the circuit board 130. Through this, as illustrated in FIG. 1, at least one region of the circuit board 130. adjacent to the side surface of the circuit board 130 may be located between the main region 151 and the wing region 152 of the circuit cover portion 150.

The connection region 153 may include a region electrically connected to the protective panel 120 in a different region from where the wing region 152 is located. In some embodiments, the connection region 153 may be disposed in a region of the main region 151, i.e., may be part of the main region 151.

The circuit cover portion 150, the circuit board 130, and the protective panel 120 are described in more detail with reference to FIG. 2. FIG. 2 is an enlarged view of region K of FIG. 1.

Referring to FIG. 2, the circuit board 130 may include at least one conductive region 131, and for example, the conductive region 131 may include a grounding conductive layer or a grounding conductive pattern.

In some embodiments, the circuit board 130 may include a first insulating base layer 132 disposed on one surface of the conductive region 131 and a second insulating base layer 133 disposed on another surface, e.g., an opposite surface, of the conductive region 131.

In some embodiments, the conductive region 131 may be located between the first insulating base layer 132 and the second insulating base layer 133.

The circuit board 130 may include a conductive exposure region 131A in at least one region. In some embodiments, the conductive exposure region 131A may be a region of the conductive region 131 including an exposed surface not covered by the first insulating base layer 132 or the second insulating base layer 133, for example, a region including an exposed surface not covered by the second insulating base layer 133.

The conductive region 131 may include various conductive materials, for example, a metal material, such as copper.

The circuit cover portion 150 may include at least one conductive layer 150c.

In some embodiments, the circuit cover portion 150 may include a first insulating layer 150a disposed on one surface of the conductive layer 150c and a second insulating layer 150b disposed on another surface, e.g., the opposite surface, of the conductive layer 150c.

In some embodiments, the conductive layer 150c may be located between the first insulating layer 150a and the second insulating layer 150b.

At least one region or the entire region of the wing region 152 of the circuit cover portion 150 may include a region of the exposed conductive layer 150c, for example, a region including an exposed surface of the conductive layer 150c not covered by the first insulating layer 150a or the second insulating layer 150b, and as an example, an exposed surface of the conductive layer 150c not covered by the first insulating layer 150a.

The conductive layer 150c may include various conductive materials, for example, a metal material, such as aluminum (Al). The first insulating layer 150a or the second insulating layer 150b may include various insulating materials, for example, may include organic substances and may include a resin-based material. In an embodiment, the first insulating layer 150a or the second insulating layer 150b may include a polyethylene series material, and as an example, may include polyethylene terephthalate (PET).

In some embodiments, the conductive region 131 of the circuit board 130 is electrically connected to the conductive layer 150c of the circuit cover portion 150. In some embodiments, the conductive region 131 of the circuit board 130 is connected through direct contact to the conductive layer 150c of the circuit cover portion 150. In some embodiments, as an example, a conductive material may be located between the conductive region 131 of the circuit board 130 and the conductive layer 150c of the circuit cover portion 150, for example, a conductive tape may be disposed, or as an embodiment, a conductive adhesive material may be disposed.

In some embodiments, an exposed surface of the surface of the conductive layer 150c of the wing region 152 of the circuit cover portion 150 not covered by the first insulating layer 150a may correspond to a region in which the conductive region 131 of the circuit board 130 is exposed, that is, the conductive exposure region 131A, and accordingly, the conductive layer 150c of the wing region 152 may be in contact with the conductive region 131 of the circuit board 130.

As a result, the circuit board 130 may be electrically connected to the circuit cover portion 150, and for example, a grounding region for conducting of the circuit board 130 may be electrically connected to the circuit cover portion 150 to form an electrical path. As such, an electrical path for grounding of the circuit board 130 may be connected from the conductive region 131 of the circuit board 130 to the conductive layer 150c of the wing region 152 of the circuit cover portion 150 through the conductive exposure region 131A, the conductive layer 150c may be connected or integrally extend to the connection region 153 of the circuit cover portion 150, and the conductive layer 150c of the connection region 153 may be connected to the protective conductive layer (see 121 of FIG. 5) of the protective panel 120.

As a result, a grounding path for the circuit board 130 may be easily implemented. In some embodiments, instead of forming a grounding path through direct contact between the circuit board 130 and the protective panel 120, an electrical connection between the circuit board 130 and the circuit cover portion 150 and an electrical connection between the circuit cover portion 150 and the protective panel 120 may be implemented, thereby facilitating stable placement of the circuit board 130 and the protective panel 120 and reducing or preventing a difficulty of adjacent conductive ground connections.

In order to ensure stable placement of the circuit cover portion 150 and the protective panel 120 with respect to each other, a bonding member, for example, an adhesive layer ADH may be disposed in at least one region between the circuit cover portion 150 and the protective panel 120. In some embodiments, the adhesive layer ADH may be located between the second insulating layer 150b of the circuit cover portion 150 and the protective panel 120. In an embodiment, the adhesive layer ADH may be disposed up to the circuit board 130, for example, up to the second insulating base layer 133 of the circuit board 130.

The electrical connection between the protective panel 120 and the circuit cover portion 150 is described in more detail with reference to FIGS. 3 to 5.

FIG. 3 is a schematic plan view viewed in direction A of FIG. 1. FIG. 4 is a cross-sectional view taken along line IV-IV' of FIG. 3. FIG. 5 is an enlarged view of Q in FIG. 4.

Referring to FIG. 3, the circuit cover portion 150 is shown to be bent to surround a region of the protective panel 120, for example, a lower edge based on FIG. 3.

In some embodiments, FIG. 3 may illustrate the rear surface, which is the opposite surface of the front surface in which an image of the display apparatus 100 is implemented, and as an embodiment, one region of the circuit cover portion 150 is not visible but may be bent to surround at least one region of the edge of the display panel 110 and be connected to one surface of the display panel 110.

For convenience of description, FIG. 3 may be a schematic perspective plan view.

The wing region 152 of the circuit cover portion 150 may be bent or folded while being connected to the main region 151, or in other words, folded to overlap a region of the circuit board 130, and may, for example, come into contact with or cover the conductive exposure region 131A (see FIG. 2) of the circuit board 130.

In some embodiments, the main region 151 of the circuit cover portion 150 may be bent or folded along a reference line in the length direction (the X-axis direction in FIG. 3) to cover a region of the protective panel 120.

The connection region 153 of the circuit cover portion 150 may be disposed in a region of the main region 151 and overlap the protective panel 120. In an embodiment, the connection region 153 of the circuit cover portion 150 may be located closer to the edge of the circuit cover portion 150 than the wing region 152 in the width direction (the Y-axis direction in FIG. 3) of the circuit cover portion 150. In some embodiments, the connection region 153 may be located between the wing region 152 and one edge of the circuit cover portion 150, and as an example, the connection region 153 may be connected to the edge of the circuit cover portion 150.

Referring to FIG. 4, a cross-sectional view illustrating the connection region 153 of the circuit cover portion 150 is illustrated, and FIG. 5 is an enlarged view of Q of FIG. 4.

At least one region or the entire region of the connection region 153 of the circuit cover portion 150 may include a region of the exposed conductive layer 150c, for example, a region including an exposed surface of the conductive layer 150c that is not covered by the first insulating layer 150a or the second insulating layer 150b, and as an example, an exposed surface of the conductive layer 150c not covered by the first insulating layer 150a.

The protective panel 120 may include the protective conductive layer 121, and the protective conductive layer 121 may correspond to the outermost surface of the protective panel 120. In some embodiments, the protective panel 120 may include one or more protective layers on the outermost portion thereof and may include the protective conductive layer 121 exposed and not covered by a protective layer.

The conductive layer 150c of the connection region 153 of the circuit cover portion 150 may directly contact the protective conductive layer 121 of the protective panel 120.

Through this, as described above, an electrical path may be stably implemented from the grounding region of the circuit board 130 to the protective conductive layer 121 of the circuit cover portion 150.

In other words, the conductive exposure region 131A of the conductive region 131 of the circuit board 130 may be in contact with and electrically connected to the conductive layer 150c of the wing region 152 of the circuit cover portion 150, and the conductive layer 150c of the wing region 152 may be connected to or integrally extend to the conductive layer 150c of the connection region 153.

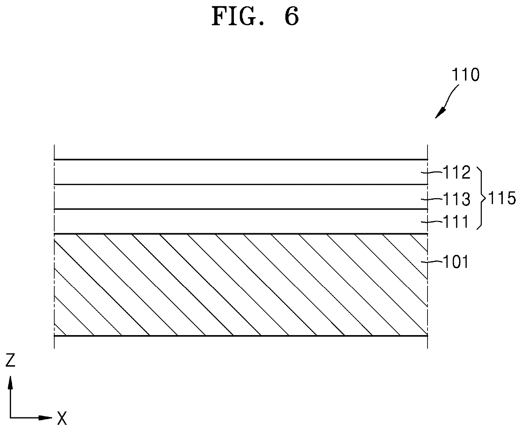

FIG. 6 is a cross-sectional view schematically illustrating an example of the display panel 110 of FIG. 1.

Referring to FIG. 6, the display panel 110 may include a substrate 101 and a display element 115. As described above, the display element 115 may include various types, and in the present embodiment, for convenience of description, the display element 115 is described as including an organic light-emitting element.

The display element 115 may include a first electrode 111, a second electrode 112, and an intermediate layer 113.

The substrate 101 may include various materials. In some embodiments, the substrate 101 may be formed of glass, metal, organic substance, or other materials.

As an embodiment, the substrate 101 may be formed of a flexible material. In some embodiments, the substrate 101 may be formed to be easily bendable, pliable, foldable, or rollable.

As an embodiment, the substrate 101 may include ultra-thin glass, metal or plastic. In some embodiments, in the case of using plastic, the substrate 101 may include polyimide (PI). In some embodiments, the substrate 101 may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polycarbonate, triacetate cellulose, and cellulose acetate propionate.

In some embodiments, the substrate 101 may have a structure of one or more layers, for example, a plurality of layers. In some embodiments, the substrate 101 may include an organic layer (e.g., a resin-based material) and an inorganic layer, and as an example, may include a structure in which an inorganic layer is located between two organic layers.

In an embodiment, one or more insulating layers (not shown) may be disposed on the substrate 101.

In an embodiment, one or more thin film transistors (not shown) may be arranged on the substrate 101.

The first electrode 111 may be disposed on the substrate 101. In an embodiment, one or more insulating layers may be disposed on the substrate 101, in which case one or more insulating layers may be located between the first electrode 111 and the substrate 101.

In an embodiment, one or more thin film transistors may be arranged on the substrate 101, in which case one or more thin film transistors may be arranged between the first electrode 111 and the substrate 101.

The first electrode 111 may have various shapes, for example, may be patterned and formed in an island shape.

The first electrode 111 may include various conductive materials. In some embodiments, the first electrode 111 may include at least one selected from the group consisting of transparent conductive oxides, such as indium tin oxide (ITO), indium zinc oxide (IZO), zinc oxide (ZnO), indium oxide (In₂O₃), indium gallium oxide (IGO), and aluminum zinc oxide (AZO). In some embodiments, the first electrode 111 may include a metal with high reflectivity, such as silver (Ag).

In an embodiment, the first electrode 111 may include a multilayer structure, for example, a multilayer structure including the materials described above, including at least one layer including a transparent conductive oxide, such as ITO, IZO, ZnO, In₂O₃, IGO, AZO, and one or more layers including a metal, such as Ag.

In some embodiments, the first electrode 111 may include a three-layer structure or more, may include a metal layer between two transparent conductive oxide layers, and may include a three-layer structure of, for example, ITO/Ag/ITO.

The second electrode 112 may be disposed to face the first electrode 111. The second electrode 112 may include various conductive materials. In some embodiments, the second electrode 112 may include lithium (Li), calcium (Ca), lithium fluoride (LiF), aluminum (Al), magnesium (Mg), or silver (Ag), and may be formed as a single layer or multiple layers of at least one of the materials, and may include an alloy material including at least two of the materials.

The intermediate layer 113 may include an organic light-emitting layer and may be located between the first electrode 111 and the second electrode 112. The organic light-emitting layer of the intermediate layer 113 may include a low-molecular organic substance or a high-molecular organic substance. In an embodiment, the intermediate layer 113 may further include at least one selected from the group consisting of a hole injection layer, a hole transport layer, an electron transport layer, and an electron injection layer, together with the organic light-emitting layer.

Although not shown, in an embodiment, one or more encapsulation members or encapsulation films may be formed on the second electrode 112 to cover the second electrode 112.

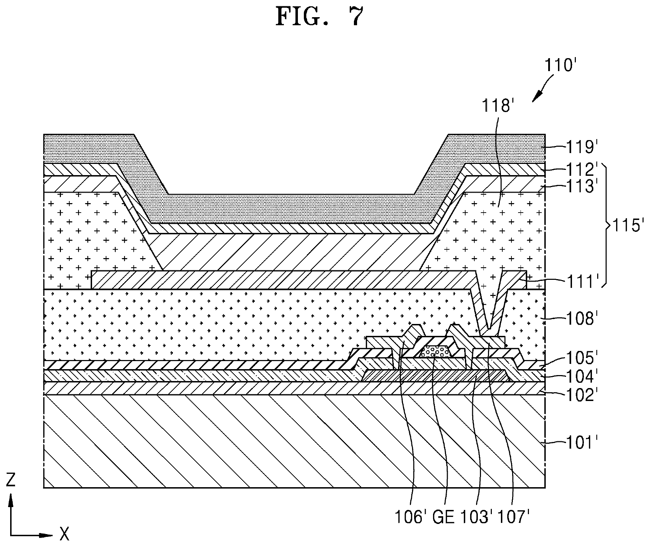

FIG. 7 is a cross-sectional view schematically illustrating an example of the display panel of FIG. 1.

Referring to FIG. 7, a display panel 110' may include a substrate 101' and a display element 115'. As described above, the display element 115' may include various types, and in the present embodiment, for convenience of description, the display element 115' is described as including an organic light-emitting element.

The display element 115' may include a first electrode 111', a second electrode 112', and an intermediate layer 113'.

In some embodiments, the display panel 110' may include one or more thin film transistors, a pixel defining film 118', etc., arranged on the substrate 101'.

For convenience of description, differences from the embodiment described above are mainly described.

The substrate 101' may include various materials. In detail, the substrate 101' may be formed of glass, metal, organic substance, or other materials, and the details may be modified and applied within a range substantially the same as or similar to the substrate 101 of the aforementioned embodiment, so a description thereof is omitted.

In an embodiment, one or more buffer layers 102' may be disposed on the substrate 101'.

A buffer layer 102' may be disposed on the substrate 101'. The buffer layer 102' may reduce or prevent diffusion of impurities into a thin film transistor to be disposed thereon.

The buffer layer 102' may include various materials, e.g., inorganic materials. In some embodiments, the buffer layer 102' may include a silicone series material. As an embodiment, the buffer layer 102' may include at least one of silicon nitride (SiNx), silicon oxide (SiOx), and silicon oxynitride (SiOxNy).

In some embodiments, the buffer layer 102' may include an oxide, and as an example may include a metal oxide, such as aluminum oxide (AlOx).

In an embodiment, the buffer layer 102' may include multiple layers of at least two or more layers

A thin film transistor may be disposed on the buffer layer 102', and this thin film transistor may function as part of a circuit for emitting visible light from the intermediate layer 113'.

Hereinafter, with reference to FIG. 7, a case in which a thin film transistor is a top gate type in which an active layer 103', a gate electrode GE, a source electrode 106', and a drain electrode 107' are formed sequentially is described.

However, the present embodiment is not limited thereto, and various types of thin film transistors, such as a bottom gate type, may be applied.

The active layer 103' is formed on the buffer layer 102'. The active layer 103' may include a semiconductor material and may include, for example, amorphous silicon or polycrystalline silicon. However, the present embodiment is not limited thereto, and the active layer 103' may include various materials. As an embodiment, the active layer 103' may include an organic semiconductor material.

As an embodiment, the active layer 103' may include an oxide semiconductor material. In some embodiments, the active layer 103' may include an oxide of a material selected from group 12, 13, or 14 metal elements, such as zinc (Zn), indium (In), gallium (Ga), tin (Sn), cadmium (Cd), germanium GE, or hafnium (Hf), and combinations thereof.

A gate insulating layer 104' is formed on the active layer 103'. The gate insulating film 104' may be formed as a multilayer or single layer film formed of an inorganic material, such as silicon oxide and/or silicon nitride. The gate insulating film 104' serves to insulate the active layer 103' from the gate electrode GE.

The gate electrode GE is formed on top of the gate insulating film 104'. The gate electrode GE may be connected to a gate line (not shown) that transmits one or more electrical signals.

The gate electrode GE may include a low-resistance metal material and may be formed of a multilayer or single layer film formed of a conductive material including, for example, molybdenum (Mo), aluminum (Al), copper (Cu), titanium (Ti), etc.

An interlayer insulating film 105' is formed on the gate electrode GE. The interlayer insulating film 105' insulates a source electrode 106' and a drain electrode 107' from the gate electrode GE.

The interlayer insulating film 105' may be formed as a multilayer or single layer film formed of an inorganic material. In some embodiments, the inorganic material may be a metal oxide or a metal nitride and may include, for example, silicon oxide (SiO₂), silicon nitride (SiNx), silicon oxynitride (SiON), aluminum oxide (Al₂o₃), titanium oxide (TiO₂), tantalum oxide (Ta₂O₅), hafnium oxide (HfO₂), or zinc oxide (ZrO₂).

The source electrode 106' and the drain electrode 107' are formed on the interlayer insulating film 105'. The source electrode 106' and the drain electrode 107' may be formed as a single layer or multiple layers using a material with good conductivity.

The source electrode 106' and the drain electrode 107' are formed to be in contact with a region of the active layer 103'.

A passivation film 108' may be disposed on the source electrode 106' and the drain electrode 107' to cover the thin film transistor.

The passivation film 108' eliminates a step caused by the thin film transistor and flattens an upper surface, thereby reducing or preventing display performance defects of the display panel 110' due to a lower unevenness.

The passivation film 108' may include an insulating material, and may include a single layer or multiple layers of a film including, for example, an organic material.

In some embodiments, the passivation film 108' may include a general-purpose polymer, such as polymethylmethacrylate (PMMA) or polystyrene (PS), which is an organic material, a polymer derivative having a phenol group, an acrylic polymer, an imide polymer, an aryl ether polymer, an amide polymer, a fluorinated polymer, a p-xylene polymer, a vinyl alcohol polymer, and blends thereof. In some embodiments, the passivation film 108' may be formed as a composite stack of an inorganic insulating film and an organic insulating film.

The first electrode 111' may be disposed on the passivation film 108'. The first electrode 111' may be electrically connected to one of the source electrode 106' or the drain electrode 107'.

The first electrode 111' may include various conductive materials, and because the materials thereof are the same as that of the first electrode 111 of the previous embodiment described above, a description thereof is omitted.

The second electrode 112' may be disposed to face the first electrode 111'. The second electrode 112' may be formed of various conductive materials. In some embodiments, the second electrode 112' may include lithium (Li), calcium (Ca), lithium fluoride (LiF), aluminum (Al), magnesium (Mg), or silver (Ag) and may be formed as a single layer or multiple layers of at least one of the materials, and may include an alloy material including at least two of the materials.

The intermediate layer 113' may include an organic light-emitting layer and may be located between the first electrode 111' and the second electrode 112'. The organic light-emitting layer of the intermediate layer 113' may use a low-molecular organic substance or a high-molecular organic substance. As an embodiment, the intermediate layer 113' may further include at least one selected from the group consisting of a hole injection layer, a hole transport layer, an electron transport layer, and an electron injection layer, together with the organic light-emitting layer.

After the pixel defining film 118' is located not to cover a preset region of the first electrode 111', an intermediate layer 113' may be located on a region of the first electrode 111' that is not covered by the pixel defining film 118', and the second electrode 112' may be located on the intermediate layer 113'.

The pixel definition film 118' may include various insulating materials. In some embodiments, the pixel definition film 118' may include an organic material and may be formed by a method, such as spin coating using one or more organic insulating materials selected from the group consisting of polyimide, polyamide, acrylic resin, benzocyclobutene, and phenol resin.

An encapsulation portion 119' may be disposed on top of the second electrode 112'. In some embodiments, the encapsulation portion 119' may have one or more encapsulation layers. In an embodiment, the encapsulation portion 119' may include one or more inorganic layers or one or more organic layers, and as an example, may include a structure in which inorganic layers and organic layers are alternately stacked one or more times, and as an example, may include a structure in which inorganic layers and organic layers are alternately stacked a plurality of times.

In some embodiments, the encapsulation portion 119' may be used as a substitute for a substrate-type encapsulation substrate, thereby reducing the thickness of a display apparatus and an electronic device including the same and improving bending characteristics.

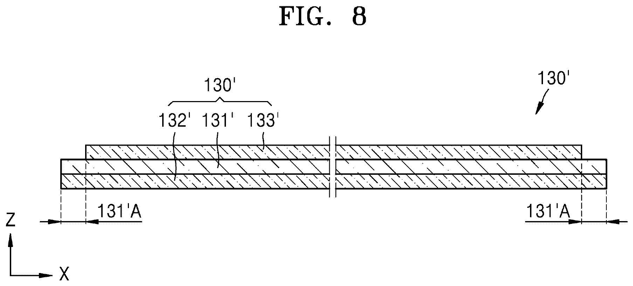

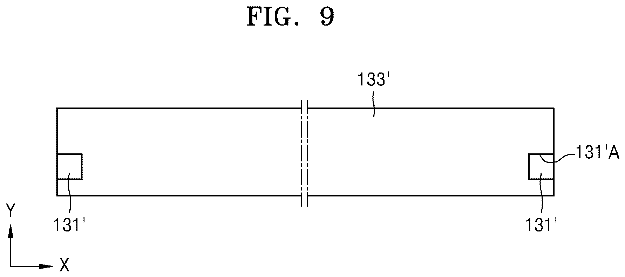

FIG. 8 is a cross-sectional view illustrating an example of a circuit board 130' of the display apparatus of FIG. 1. FIG. 9 is a plan view of FIG. 8, viewed from one direction.

Referring to FIGS. 8 and 9, the circuit board 130' may have a length in one direction (the X-axis direction of FIGS. 8 and 9) and a width in a direction intersecting the one direction (the Y-axis direction of FIGS. 8 and 9).

The circuit board 130' may include a conductive region 131', and for example, the conductive region 131' may include a grounding conductive layer or a grounding conductive pattern.

In some embodiments, the circuit board 130' may include a first insulating base layer 132' disposed on one surface of the conductive region 131' and a second insulating base layer 133' disposed on another surface, e.g., the opposite surface, of the conductive region 131.

In some embodiments, the conductive region 131' may be located between the first insulating base layer 132' and the second insulating base layer 133'.

The circuit board 130' may include a conductive exposure region 131'A in at least one region. In some embodiments, the conductive exposure region 131'A may be a region of the conductive region 131' including a surface that is exposed and not covered by the first insulating base layer 132' or the second insulating base layer 133', for example, a surface that exposed and not covered by the second insulating base layer 133'. In some embodiments, FIG. 2 may include a right region of the circuit board 130' of FIG. 8.

Referring to FIGS. 8 and 9, the conductive exposure region 131'A may be formed on one surface of the circuit board 130', for example, on a region of a surface facing the second insulating base layer 133', and the conductive exposure region 131'A may be formed adjacent to both corresponding side edges in the length direction of the circuit board 130' (the X-axis direction of FIGS. 8 and 9).

These conductive exposure regions 131'A may be formed to have a length less than a length of the circuit board 130' and a width less than a width of the circuit board 130'. In some embodiments, the shape and size of the conductive exposure region 131'A may be determined to correspond to a set size for grounding of the circuit board 130'.

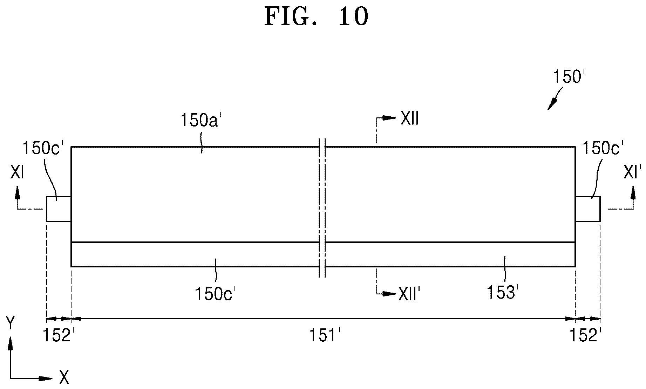

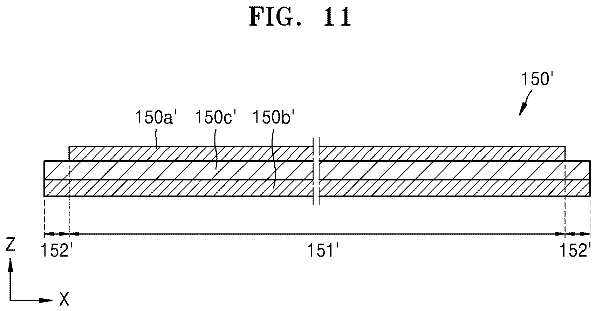

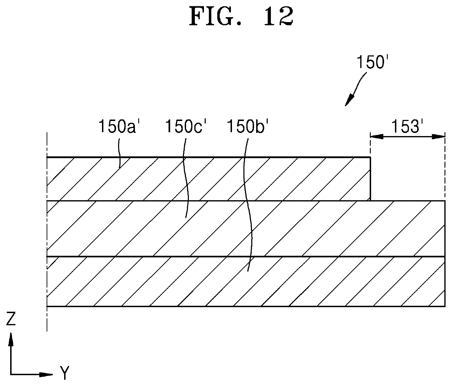

FIG. 10 is a plan view illustrating an example of a circuit cover portion of the display apparatus of FIG. 1. FIG. 11 is a cross-sectional view taken along line XI-XI' of FIG. 10. FIG. 12 is a cross-sectional view taken along line XII-XII' of FIG. 10.

The circuit cover portion 150' may be formed to cover at least one region of the circuit board 130', and as an example, may have a region equal to or larger than the circuit board 130' to cover the entire circuit board 130'.

The circuit cover portion 150' may include at least a main region 151', a wing region 152', and a connection region 153'.

The main region 151' of the circuit cover portion 150' may have a length in one direction (the X-axis direction of FIGS. 10 and 11) and a width in a direction (the Y-axis direction of FIGS. 10 and 12) intersecting the one direction.

The wing region 152' may be connected to the main region 151' and may protrude from the main region 151' in the length direction. Also, this wing region 152' may be bent to overlap the main region 151', and through this, when the circuit board 130' and the circuit cover portion 150' are disposed, the wing region 152' may be bent or folded to correspond to or overlap the conductive exposure region 131'A of the circuit board 130'.

The connection region 153' may include a region electrically connected to the protective panel 120' in a region different from the wing region 152'. In some embodiments, the connection region 153' may be disposed in a region of the main region 151'.

The circuit cover portion 150' may include at least one conductive layer 150c'.

In some embodiments, the circuit cover portion 150' may include a first insulating layer 150a' disposed on one surface of the conductive layer 150c' and a second insulating layer 150b' disposed on another surface, e.g., the opposite surface, of the conductive layer 150c'.

In some embodiments, the conductive layer 150c' may be located between the first insulating layer 150a' and the second insulating layer 150b'.

At least one region or the entire region of the wing region 152' of the circuit cover portion 150' may include a region of the exposed conductive layer 150c', for example, a region including a surface of the conductive layer 150c' that is exposed and not covered by the first insulating layer 150a' or the second insulating layer 150b', and as an example, may include a surface of the conductive layer 150c' that is exposed and not covered by the first insulating layer 150a'.

At least one region or the entire region of the connection region 153' of the circuit cover portion 150' may include a region of the exposed conductive layer 150c', for example, a region including a surface of the conductive layer 150c' that is exposed and not covered by the first insulating layer 150a' or the second insulating layer 150b', and as an example, may include a surface of the conductive layer 150c' that is exposed and not covered by the first insulating layer 150a'.

FIG. 10 illustrates that the connection region 153' is formed to correspond to the length of the main region of the circuit cover portion 150' (based on the X-axis direction of FIGS. 10 and 11), but may have a shorter length.

Also, in FIG. 10, the connection region 153' is shown as being formed to extend to the edge of the circuit cover portion 150', but it may also be formed to be apart from the edge.

After the circuit cover portion 150' of FIGS. 10 to 12 is disposed to overlap the circuit board 130' of FIGS. 8 and 9, the wing region 152' of the circuit cover portion 150' located to protrude from both sides of the circuit board 130' may be bent or folded so that the conductive layer 150c' of the wing region 152' of the circuit cover portion 150' overlaps the conductive exposure region 131'A of the circuit board 130' so that at least one region is in contact.

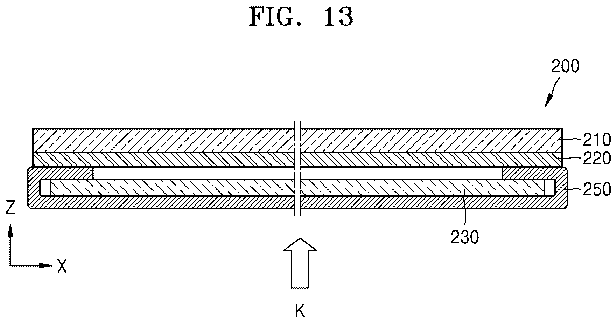

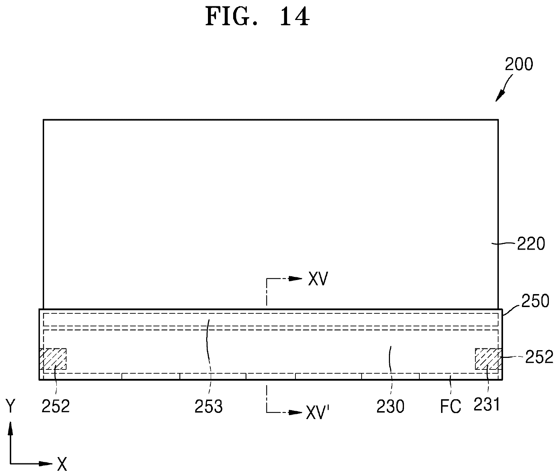

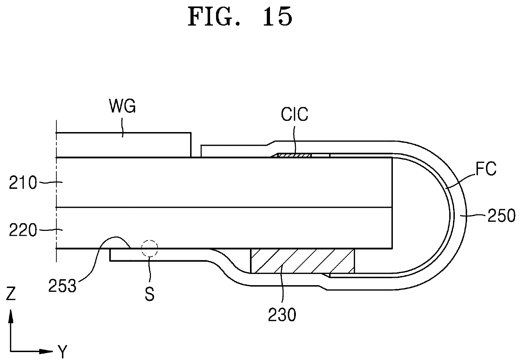

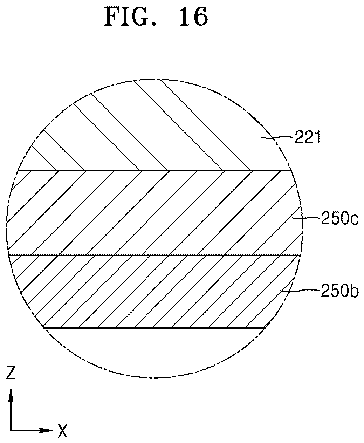

FIG. 13 is a cross-sectional view schematically illustrating a display apparatus 200 according to an embodiment of the present invention. FIG. 14 is a plan view viewed in direction K of FIG. 13. FIG. 15 is a cross-sectional view taken along line XV-XV' of FIG. 14. FIG. 16 is an enlarged view of region S of FIG. 15.

Referring to FIGS. 13 and 14, the display apparatus 200 may include a display panel 210, a protective panel 220, a circuit board 230, and a circuit cover portion 250.

The display apparatus 200 of FIG. 13 may be the same as or similar to the display apparatus 100 of FIG. 1 described above. In some embodiments, the display apparatus 200 of FIG. 13 includes both edges of the display apparatus 100 compared to the display apparatus 100 of FIG. 1 and includes a form in which the circuit cover portion 250 and a connecting circuit portion FC adjacent thereto are bent to the rear surface on one side of the display panel. This is described in detail below.

The display panel 210 may include a display unit that generates visible light. In some embodiments, the display panel 210 may include one or more display elements arranged on a substrate, and the display elements may be OLEDs, and as embodiments, may include liquid crystal displays (LCDs), light emitting diodes (LEDs), quantum dot elements, etc. In some embodiments, the display panel 210 may adopt the configurations of FIGS. 6 and 7 described above.

As illustrated in FIG. 15, an integrated circuit chip CIC may be disposed in a region of the display panel 210.

The protective panel 220 may be located to face one surface of the display panel 210. In some embodiments, when a main surface of the display panel 210 on which an image is implemented is referred to as a front surface, the protective panel 220 may be disposed to face the rear surface, which is the opposite surface of the front surface of the display panel 210. In some embodiments, because the upper surface of the display panel 210 is the front surface and the main surface on which an image is implemented based on FIG. 13, the protective panel 220 may be disposed on the lower surface of the display panel 210.

The protective panel 220 may protect the display panel 210, and for example, may reduce or prevent the display panel 210 from being damaged or deformed by external impact, and as an example, may reduce or prevent the display panel 210 from being damaged or deformed by external light, and may reduce or prevent the display panel 210 from being damaged or deformed by heat or electromagnetic waves.

In some embodiments, the protective panel 220 may include a protective layer, and as an example, a cushion layer that absorbs shock. As an example, the protective panel 220 may include a layer that absorbs external light. In some embodiments, as an example, the protective panel 220 may include a heat dissipation layer that dissipates heat or a shielding layer that shields electromagnetic waves.

As an embodiment, a cover member WG may be further disposed on one surface of the display panel 210, for example, in a region of a surface opposite to the surface facing the protective panel 220, as illustrated in FIG. 15. The cover member WG may include a light-transmitting material, for example, glass. In some embodiments, one or more optical functional layers may be located between the display panel 210 and the cover member WG. In some embodiments, one or more touch pattern layers may be formed on one surface of the display panel 210 or the cover member WG, and in addition, as an example, may be formed in a region between the display panel 210 and the cover member WG.

In some embodiments, the protective panel 220 may include one or more conductive ground layers or conductive ground patterns for grounding.

The circuit board 230 may be disposed to face the protective panel 220 to apply an electrical signal to the display panel 210. In some embodiments, the circuit board 230 may include one or more circuit regions, and may include, for example, an integrated circuit chip. In some embodiments, the circuit board 230 may include a printed circuit board.

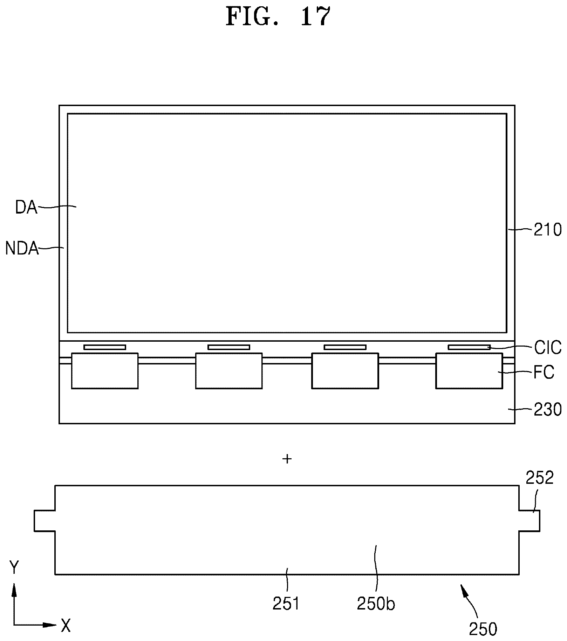

In some embodiments, the circuit board 230 may be electrically connected to the display panel 210 through a connecting circuit portion FC of FIG. 15, FIG. 17, etc.. The connecting circuit portion FC of FIG. 15 may include a material that is flexible to be bent while connected to the display panel 210 and the circuit board 230. By bending the connecting circuit portion FC, the circuit board 230 may be disposed to face one surface of the protective panel 220, while being electrically connected to the display panel 210.

The circuit cover portion 250 may be disposed to cover at least a portion of the circuit board 230, and as an example, may be disposed to cover the entire circuit board 230.

The circuit cover portion 250 may be disposed to cover a circuit region on the display panel 210, for example, a circuit region of the integrated circuit chip CIC or the circuit board 230 to protect the circuit region, and for example, protect the circuit region from external contact, pressure, or electromagnetic waves.

The circuit cover portion 250 may include at least a conductive layer and a protective insulating layer disposed on at least one surface of the conductive layer.

The circuit cover portion 250 may include at least a main region 251, a wing region 252, and a connection region 253.

The main region 251 of the circuit cover portion 250 may have a length in one direction (the X-axis direction of FIGS. 13 and 14) and a width in a direction (the Y-axis direction of FIG. 14) intersecting the one direction.

The wing region 252 may be connected to the main region 251, may be located between the circuit board 230 and the protective panel 220, and may be electrically connected to the circuit board 230. In some embodiments, the wing region 252 may protrude from the main region 251 in the length direction. The wing region 252 may be bent to overlap the main region 251. In some embodiments, the circuit board 230 may be disposed on the main region 251, and wing regions 252 that are disposed to extend to both sides of the circuit board 230 may be bent to come into contact with a region of the circuit board 230. Through this, as illustrated in FIG. 13, the side surface of the circuit board 230 or at least one region adjacent to the side surface of the circuit board 230 may be located between the main region 251 and the wing region 252 of the circuit cover portion 250.

In some embodiments, the wing region 252 may be formed on both sides of the main region 251 and folded from both sides to overlap the circuit board 230 and at least one region may be in contact and electrically connected to the circuit board 230.

The connection region 253 may include a region electrically connected to the protective panel 220 in a region different from the wing region 252. In some embodiments, the connection region 253 may be disposed in a region of the main region 251.

The configuration of the electrical connection of the circuit cover portion 250, the circuit board 230, and the protective panel 220 may be substantially the same as that described above with reference to FIG. 2.

The circuit cover portion 250 may include at least one conductive layer 250c in FIG. 16.

In some embodiments, the circuit cover portion 250 may include a first insulating layer (similar to the first insulating layer 150a' in FIG. 1) disposed on one surface of the conductive layer 250c and a second insulating layer 250b in FIG. 16 disposed on another surface, e.g., the opposite surface, of the conductive layer 250c.

In some embodiments, the conductive layer 250c may be located between the first insulating layer and the second insulating layer 250b.

At least one region or the entire region of the wing region 252 of the circuit cover portion 250 may include a region of the exposed conductive layer 250c, for example, a region including a surface of the conductive layer 250c that is exposed and not covered by the first insulating layer or the second insulating layer 250b, and as an example, may include a surface of the conductive layer 250c that is exposed and not covered by the first insulating layer.

The conductive layer 250c may include various conductive materials, for example, a metal material, and as an example, aluminum (Al). The first insulating layer or the second insulating layer 250b may include various insulating materials, for example, may include organic substances, and as an example, may include a resin-based material. As an embodiment, the first insulating layer or the second insulating layer 250b may include a polyethylene series material, and as an example, may include polyethylene terephthalate (PET).

In some embodiments, a conductive region 231 of the circuit board 230 is electrically connected to the conductive layer 250c of the circuit cover portion 250, for example, through direct contact.

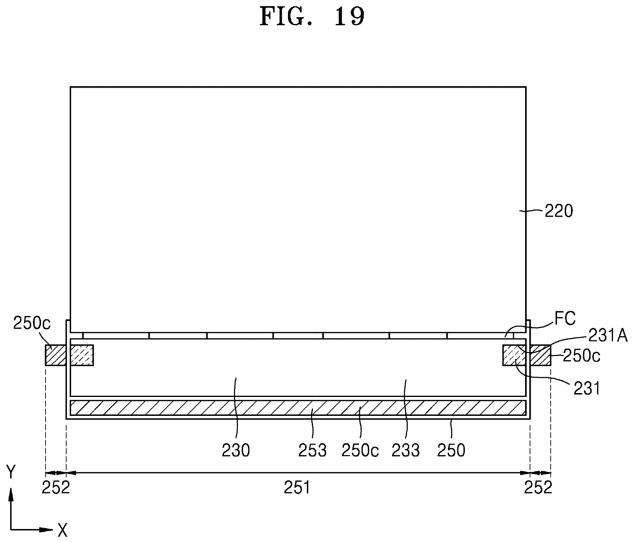

In some embodiments, an exposed surface of the surface of the conductive layer 250c of the wing region 252 of the circuit cover portion 250 not covered by the first insulating layer may correspond to a region in which the conductive region 231 of the circuit board 230 is exposed, that is, the conductive exposure region 231A (see FIG. 19), and accordingly, the conductive layer 250c of the wing region 252 may be in contact with the conductive region 231 of the circuit board 230.

As a result, the circuit board 230 may be electrically connected to the circuit cover portion 250, and for example, a conductive grounding region of the circuit board 230 may be electrically connected to the circuit cover portion 250 to form an electrical path. Through this, an electrical path for grounding from the circuit board 230 may be connected from the conductive region 231 of the circuit board 230 to the conductive layer 250c of the wing region 252 of the circuit cover portion 250 through the conductive exposure region 231A, the conductive layer 250c may extend up to the connection region 253 of the circuit cover portion 250, and the conductive layer 250c of the connection region 253 may be connected to a protective conductive layer 221 of the protective panel 220.

Through this, the grounding function for the circuit board 230 may be easily implemented. In some embodiments, instead of forming a direct grounding path for the circuit board 230 and the protective panel 220, a stable arrangement of the circuit board 230 and the protective panel 220 may be facilitated by including an electrical connection between the circuit board 230 and the circuit cover portion 250 and an electrical connection between the circuit cover portion 250 and the protective panel 220, and the difficulty of conductive connections adjacent to each other may be reduced or prevented.

The electrical connection between the protective panel 220 and the circuit cover portion 250 is described in more detail with reference to FIGS. 14 to 16.

Referring to FIG. 14, the circuit cover portion 250 is shown to be bent to surround a region of the protective panel 220, for example, a lower edge based on FIG. 14.

For convenience of description, FIG. 14 may be a schematic perspective plan view.

The wing region 252 of the circuit cover portion 250 may be bent or folded while connected to the main region 251 to overlap a region of the circuit board 230, and may, for example, come into contact with or cover the conductive exposure region 231A (see FIG. 19) of the circuit board 230.

In some embodiments, the main region 251 of the circuit cover portion 250 may be bent or folded along a reference line in the length direction (X-axis direction of FIG. 14) to cover a region of the protective panel 220.

The connection region 253 of the circuit cover portion 250 may be disposed in a region of the main region 251 and overlap the protective panel 220. As an embodiment, the connection region 253 of the circuit cover portion 250 may be located closer to the edge of the circuit cover portion 250 than the wing region 252 in the width direction (Y-axis direction in FIG. 14) of the circuit cover portion 250. In some embodiments, the connection region 253 may be located between the wing region 252 and one edge of the circuit cover portion 250.

At least one region or the entire region of the connection region 253 of the circuit cover portion 250 may include a region of the exposed conductive layer 250c, for example, a region including an exposed surface of the conductive layer 250c not covered by the first insulating layer or the second insulating layer 250b, and as an example, an exposed surface of the conductive layer 250c not covered by the first insulating layer.

The protective panel 220 may include the protective conductive layer 221, and the protective conductive layer 221 may correspond to the outermost surface of the protective panel 220. As an example, the protective panel 220 may include one or more protective layers at the outermost portion and may include the protective conductive layer 221 that is exposed and not covered by a protective layer.

The conductive layer 250c of the connection region 253 of the circuit cover portion 250 may be in direct contact with the protective conductive layer 221 of the protective panel 220.

Through this, as described above, an electrical path may be stably implemented from the grounding region of the circuit board 230 to the protective conductive layer 221 of the circuit cover portion 250.

In other words, the conductive exposure region 231A of the conductive region 231 of the circuit board 230 may be connected to the conductive layer 250c of the wing region 252 of the circuit cover portion 250, and the conductive layer 250c of the wing region 252 may be formed to be connected to or integrally extend to the conductive layer 250c of the connection region 253.

FIGS. 17 to 21 are views illustrating an example of disposing a circuit cover portion 250 of the display apparatus 200 of FIG. 13.

Referring to FIG. 17, the display panel 210 may include a display region DA and a non-display region NDA. The non-display region NDA may be located on at least one side of the display region DA, as an example, on both sides of the display region DA, or as an example, may be located to surround the display region DA.

One or more integrated circuit chips CIC may be disposed in the non-display region NDA of the display panel 210.

The circuit board 230 may be electrically connected to the display panel 210 through the connection circuit portion FC.

The circuit cover portion 250 may be prepared and disposed on a circuit board 230. In some embodiments, the surface of the circuit cover portion 250 illustrated in FIG. 17 may be the second insulating layer 250b of the circuit cover portion 250.

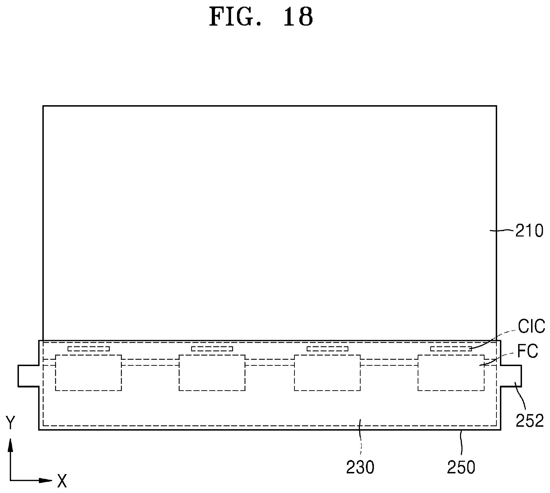

Thereafter, referring to FIG. 18, the circuit cover portion 250 may be disposed on the circuit board 230, and for example, the circuit cover portion 250 may be disposed to cover the circuit board 230.

For convenience of description, FIG. 19 is a view of FIG. 18 from the opposite side. In some embodiments, FIG. 18 illustrates the front surface of the display apparatus 200 on which an image is implemented, for example, a surface facing the display panel 210, and FIG. 19 illustrates the rear surface of the display apparatus 200 as an opposite surface, for example, a surface facing the protective panel 220.

Referring to FIGS. 18 and 19, the circuit cover portion 250 may have a region equal to or greater than at least the circuit board 230 to cover the entire circuit board 230. In some embodiments, at least the circuit cover portion 250 may have a width in one direction (the Y-axis direction of FIGS. 18 and 19) and may be formed so that the width is greater than the width of the circuit board 230, thereby allowing the circuit cover portion 250 to be formed to pass over the circuit board 230 in the width direction.

The connection region 253 of the circuit cover portion 250 may be located to be apart from the circuit board 230 in a region that passes over the circuit board 230 in the width direction (the Y-axis direction in FIG. 18) of the circuit cover portion 250. The conductive layer 250c of the connection region 253 may be apart from the circuit board 230. In FIG. 19, the connection region 253 of the circuit cover portion 250 is illustrated as not being formed to both edges of the circuit cover portion 250 and the edges (the lower end of FIG. 19) intersecting it.

As an embodiment, the connection region 253 may be formed to be connected to both edges of the circuit cover portion 250 and the edge (the lower end of FIG. 19) intersecting it, and for example, the structure of the circuit cover portion 150' of FIGS. 10 to 12 described above may be selectively applied.

In some embodiments, when disposing the circuit cover portion 250, the wing region 252 may correspond to or be parallel to the conductive exposure region 231A of the circuit board 230 and may be disposed so that there is at least a horizontally overlapping region. Through this, as described below, the wing region 252 may be folded so that the conductive layer 250c of the wing region 252 overlaps and comes into contact with the conductive exposure region 231A.

The order and method of disposing the circuit cover portion 250 and the circuit board 230 may vary, and for example, after disposing the circuit cover portion 250 and the connection circuit portion FC, the circuit board 230 may be disposed on the circuit cover portion 250.

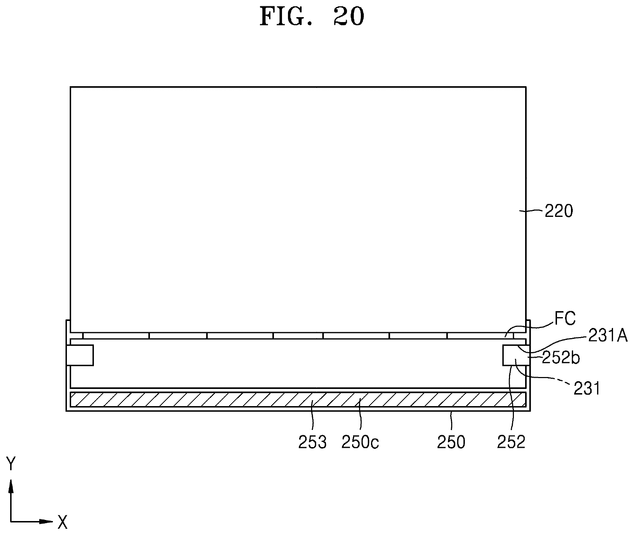

Referring to FIG. 20, the wing region 252 of the circuit cover portion 250 is bent or folded toward the circuit board 230 to overlap or come into contact with the circuit board 230. In some embodiments, the conductive layer 250c of the wing region 252 may be folded to come into contact with the conductive exposure region 231A of the circuit board 230.

At this time, as an embodiment, the wing region 252 may be disposed to entirely cover the conductive exposure region 231A of the circuit board 230, thereby stably disposing the circuit board 230, improving the reliability of the electrical connection between the conductive exposure region 231A of the circuit board 230 and the conductive layer 250c of the wing region 252, and easily implementing a smooth path for grounding of the circuit board 230.

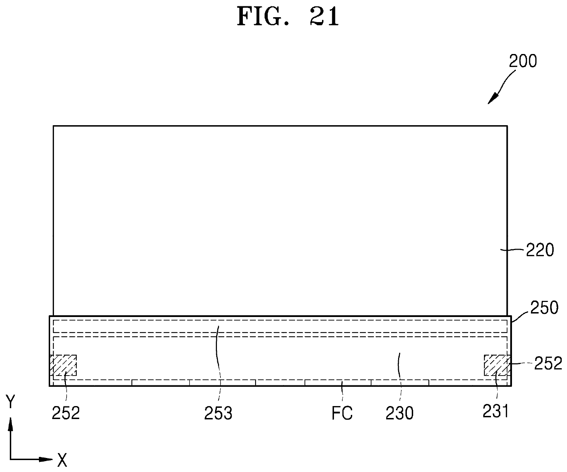

Referring to FIG. 21, a region of the circuit cover portion 250 may be bent and disposed on the protective panel 220, and disposed to be in contact with the protective panel 220.

In some embodiments, the connection circuit portion FC and the circuit cover portion 250 may be bent based on an overlapping region (e.g., an imaginary line in the X-axis direction of FIG. 20), through which the connection region 253 of the circuit cover portion 250 may overlap the protective panel 220, and as an example, the conductive layer 250c of the connection region 253 may be in direct contact with the protective conductive layer 221 of the protective panel 220 (see FIGS. 15 and 16).

At this time, in order to ensure stable placement of the circuit cover portion 250 and the protective panel 220, a bonding member, for example, an adhesive layer, may be disposed in at least one region between the circuit cover portion 250 and the protective panel 220.

The display apparatus of the present embodiment includes a circuit board that applies an electrical signal to the display panel and a circuit cover portion that covers at least one region of the circuit board. The circuit cover portion may include a wing region connected to a main region, and when the circuit board is disposed to overlap the circuit cover portion, the wing region may be disposed to protrude from a side surface of the circuit board, and the wing region may be folded toward the circuit board. A conductive layer in the folded wing region may correspond to and connect, for example, contact, a conductive exposure region of the circuit board. Through this, a conductive path for grounding from the circuit board to the circuit cover portion may be implemented.

An end portion of a region different from the wing region of the circuit cover portion, for example, a region of the main region that is separated from the wing region, may be folded up to overlap the protective panel, and as an example, a connection region may overlap the protective panel.

At this time, the bent main region of the circuit cover portion may overlap the wing region, and pressure may be applied to the wing region, so that the connection or close contact between the wing region and the circuit board may be improved, the reliability of the conductive connection between the circuit board and the circuit cover portion may be improved, and the grounding stability of the circuit board may be improved.

In some embodiments, a conductive layer of a connection region of the circuit cover portion and a protective conductive layer of a protective panel may be electrically connected or in contact. Through this, the conductive layer of the connection region connected to or formed integrally with the conductive layer of the wing region of the circuit cover portion is electrically connected to the protective conductive layer of the protection panel, so that an electrical connection between the circuit board and the protective panel may be completed.

Through this, a grounding path between the circuit board, circuit cover, and protective panel may be easily implemented. There is no need for the circuit board and the protective panel to be in direct contact, and in particular, there is no need for the conductive layers to be in direct contact with each other, which may improve the convenience of arrangement and manufacturing of various members adjacent to the display panel and improve the reliability of implementing the electrical connection and grounding path.

Through embodiments of the present invention, the electrical characteristics and durability of a display apparatus may be improved.

Although the present invention has been described with reference to an embodiment shown in the drawings, this is merely an example, and those skilled in the art will understand that various modifications and variations of the embodiments are made therefrom. Therefore, the true technical protection scope of the present invention should be determined by the appended claims.

## Claims

1. A display apparatus (100) comprising:
a display panel (110) including a display element (115) generating visible light;
a protective panel (120) disposed to face one surface of the display panel (110);
a circuit board (130) disposed to face the protective panel (120) to apply an electrical signal to the display panel (110);
**characterized by**
a circuit cover portion (150) including: a main region (151), a wing region (152) connected to the main region (151), located between the circuit board (130) and the protective panel (120), and electrically connected to the circuit board (130), and a connection region (153) disposed in the main region (151) and electrically connected to the protective panel (120) in a region different from the wing region (152).

2. The display apparatus (100) of claim 1, wherein
the wing region (152) and the main region (151) overlap each other.

3. The display apparatus (100) of claim 1 or 2, wherein
at least one region of the circuit board (130) is located between the wing region (152) and the main region (151).

4. The display apparatus (100) of at least one of claims 1 to 3, wherein
a region of the wing region (152) is in direct contact with a region of the circuit board (130).

5. The display apparatus (100) of at least one of claims 1 to 4, wherein
a region of the connection region (153) is in direct contact with a region of the protective panel (120).

6. The display apparatus (100) of at least one of claims 1 to 5, wherein
the circuit cover portion (150) includes a conductive layer (150c) and an insulating layer (150a) on at least one surface of the conductive layer (150c).

7. The display apparatus (100) of claim 6, wherein
the wing region (152) includes a region in which a surface of the conductive layer (150c) is not covered with the insulating layer (150a).

8. The display apparatus (100) of claim 6 or 7, wherein
the connection region (153) includes a region in which a surface of the conductive layer (150c) is not covered with the insulating layer (150a).

9. The display apparatus (100) of at least one of claims 6 to 8, wherein
the insulating layer (150a) is a first insulating layer (150a) disposed on one surface of the conductive layer (150c) and a second insulating layer (150b) is disposed on an opposite surface of the conductive layer (150c).

10. The display apparatus (100) of at least one of claims 6 to 9, wherein
the conductive layer (150c) is disposed to correspond to the main region (151), the wing region (152), and the connection region (153).

11. The display apparatus (100) of at least one of claims 1 to 10, wherein,
the circuit board (130) includes a conductive region (131) and an insulating base layer (133) on at least one surface of the conductive region (131).

12. The display apparatus (100) of claim 11, wherein
the circuit board (130) includes at least one region having a conductive exposure region (131A), and
the conductive exposure region (131A) includes a surface of the conductive region (131) not covered by the insulating base layer (133) and exposed.

13. The display apparatus (100) of claim 12, wherein
the conductive exposure region (131A) is disposed to overlap the wing region (152).

14. The display apparatus (100) of claim 12 or 13, wherein
the conductive exposure region (131A) has a length or width less than a length or width of the circuit board (130).

15. An electronic device comprising a display apparatus (100) according to at least one of claims 1 to 14.
